Europäisches Patentamt

European Patent Office

Office européen des brevets

(19)

(11) Publication number: **0 330 524**
**A1**

(12)

# EUROPEAN PATENT APPLICATION

(21) Application number: **89301934.9**

(22) Date of filing: **27.02.89**

(51) Int. Cl.⁴: **C 23 C 16/26**
C 30 B 29/04, C 23 C 16/50,
C 23 C 16/52

(30) Priority: **26.02.88 JP 43414/88**
**02.03.88 JP 50397/88**

(43) Date of publication of application:
**30.08.89 Bulletin 89/35**

(84) Designated Contracting States: **DE FR GB**

(71) Applicant: **SEMICONDUCTOR ENERGY LABORATORY**
**CO., LTD.**
**398 Hase**
**Atsugi-shi Kanagawa-ken, 243  (JP)**

(72) Inventor: **Itoh, Kenji**
**Lion's mansion Zama 705 3-5755-1 Iriya**
**Zama-shi Kanagawa-ken  (JP)**

(74) Representative: **Milhench, Howard Leslie et al**
**R.G.C. Jenkins & Co. 26 Caxton Street**
**London SW1H 0RJ  (GB)**

(54) **Improvements relating to the deposition of thin carbon films.**

(57) While CVD (chemical vapour deposition) methods and enhanced CVD methods for coating a substrate with a carbon coating have recently been attracting considerable interest, problems have occurred hitherto of separation of the carbon coating from the underlying substrate due to differential thermal expansion or contraction. The present invention discloses a modification of the conventional CVD process for carbon deposition in accordance with which the deposition conditions are changed in order that the hardness of the carbon coating at the interface between the coating and the underlying substrate is lower than that at the external surface of the coating.

Fig. 1

EP 0 330 524 A1

Description

## Improvement Relating to the Deposition of Thin Carbon Films

### FIELD AND BACKGROUND OF THE INVENTION

This invention concerns improvements relating to the deposition of thin carbon films and more particularly relates to a method of depositing thin films consisting mainly of carbon and an apparatus for carrying out such a method.

Carbon thin films are very suitable for making surfaces abrasion-proof, smooth, or highly thermally conductive and may be deposited by use of chemical vapour reactions. A plasma state is developed in a reactive gas by applying high frequency electric energy between a pair of electrodes defining therebetween the deposition region, and by using a hydrocarbon gas and a carrier of hydrogen as the reactive gas a carbon film can be deposited on a surface. During the deposition process, positive ions, such as hydrogen ions, are impelled towards the surface to be coated by the voltage between the pair of electrodes and sputter the depositing film. This sputtering functions to reduce the formation of carbon bonds based on the sp and $sp^2$ orbitals and to increase the proportion of carbon bonds based on the $sp^3$ orbital, and as a result the carbon film tends to grow with a diamond structure.

There are two available methods for increasing the bias voltage between the pair of electrodes. One method is to decrease the pressure of the reactive gas in the deposition region. The relative energy given to the reactive gas is increased in proportion to the decrease in the amount of reactive gas in the reaction chamber. The molar ratio of ions to non-ions increases as the pressure decreases. The ions tend to linger about the electrodes and produce a self-bias therebetween. The other method is to increase the input power of the high frequency energy and directly increase the number of positive ions.

The sputtering, however, tends to damage the surface to be coated, and degrades the quality of the interface between the surface and the deposited film. In addition, the high degree of hardness of the deposited carbon itself inherently incurs a disadvantage in that, because of the hardness of the carbon film, when expansion or contraction takes place, e.g. due to temperature change, the interface between the carbon film and the underlying surface cannot withstand the forces that are caused by the differential expansion or contraction ratio between the film and the underlying surface, and eventually the film comes off the surface.

### OBJECTS AND SUMMARY OF THE INVENTION

It is therefore an object of the present invention to provide an improved carbon deposition method which can be carried out without causing damage to an underlying substrate and which is capable of depositing an excellent carbon coating having a high degree of hardness at its external surface and possessing high adhesivity to the underlying substrate.

In order to accomplish the above and other objects the present invention proposes that the deposition of carbon on to a substrate be carried out initially under conditions such as to deposit a carbon product having a relatively low hardness and then under conditions such as to deposit a carbon product having a high degree of hardness.

According to the present invention, in one of its aspects, therefore there is provided a method of depositing a thin film coating consisting mainly of carbon onto an object, said method comprising: placing the object in a reaction chamber; introducing a productive gas comprising carbon into said reaction chamber; and inputting energy into said reaction chamber in order to dissociate said carbon compound gas and deposit the carbon product of the dissociation onto a surface of said object, wherein the conditions for deposition of said carbon coating are changed in order that the hardness of the carbon product initially deposited on said surface is lower than that of the carbon product finally deposited.

The energy band gap of the carbon product that is deposited in the practice of the present invention preferably is no lower than 1.0 eV, and preferably 1.5 to 5.5 eV, its Vickers hardness is preferably no lower than 2000 $Kg/mm^2$, and preferably no lower than 4500 $Kg/mm^2$ at the external surface of the carbon coating, and the thermal conductivity of the carbon product is preferably no lower than 2.5 W/cm deg, and preferably 4.0 to 6.0 W/cm deg. When used for coating thermal heads which are subjected to frequent rubbing action, the smooth and hard surface of the deposited carbon film of the invention is very suitable. When used in integrated circuits or semiconductor devices, the high thermal conductivity of the deposited carbon film of the invention assists in the dissipation of heat generated in operation of the device and prevents the temperature of the device from rising to an intolerable level.

Other aspects and features of the invention are set forth with particularity in the appended claims and, together with the features abovementioned, will be explained in the following by reference to the accompanying drawings.

### BRIEF DESCRIPTION OF THE DRAWINGS

Fig.1 is a schematic diagram showing a CVD apparatus in accordance with the present invention;

Fig.2 is a graphical diagram showing the differences between the properties of a carbon product deposited on a substrate functioning as an anode and a carbon product deposited on a substrate functioning as a cathode;

Fig.3 is a graphical diagram showing the relationship between the input power of the high frequency electric energy that is injected into the deposition region in the practice of the present invention and the properties of deposited films;

Fig.4 is a graphical diagram showing the relationship between the pressure of reactive gas in the practice of the present invention and the properties of deposited films;

Fig.5 is a graphical diagram showing the relationships between self-bias voltage level, the input power of the high frequency electric energy, and the pressure of reactive gas that are obtained in the practice of the present invention; and

Fig.6(A) and 6(B) are graphical diagrams showing the carbon film hardness variations that are obtainable in the practice of the present invention, the graphs showing the variation of hardness with film depth.

## DETAILED DESCRIPTION OF THE EMBODIMENTS

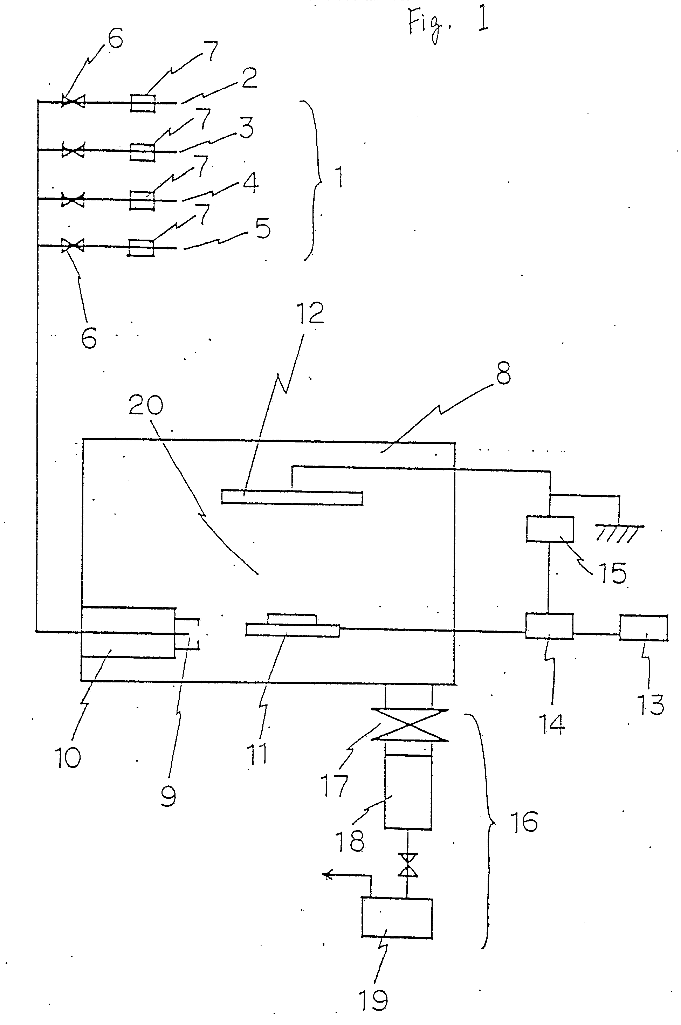

Referring to Fig.1, there is schematically shown therein a plasma CVD apparatus for depositing carbon materials on a surface in accordance with the teachings of the present invention. The surface to be coated may for example be made of semiconductor material, glass, metal, ceramics, organic resins, magnetic substances and so forth.

The apparatus comprises a reaction chamber 8 defining a reaction space 20 therein, first and second electrodes 11 and 12, a high frequency electric power source 13 for supplying electric energy through a matching transformer 14, a DC bias source 15 connected in series between the electrodes 11 and 12, a gas supply system 1 consisting of four gas supply passages 2,3,4,5 each of which is provided with a flow meter 7 and a valve 6, a microwave energy supply 10 for exciting gases from the gas supply system 1 by injection of microwave energy, a nozzle 9 through which gas excited by the microwave energy supply 10 is introduced into the reaction space 20, and an exhaust system 16 including a pressure control valve 17, a turbomolecular pump 18 and a rotary pump 19. The electrodes are designed such that (the area of the first electrode 11)/(the area of the second electrode 12) < 1.

In operation of this apparatus, a carrier gas of hydrogen is introduced to the reaction space 20 from the gas supply passage 2 together with a reactive gas comprising a hydrocarbon such as methane or ethylene for example supplied from the gas supply passage 3. The gas introduction rates of the hydrogen and the hydrocarbon gas are equal. In addition, a V-Group dopant gas such as $NH_3$ or $PH_3$, or a III-Group dopant gas may be introduced to the reaction space 20 through the gas supply passage 4 or 5 in order to form impurity semiconductors. Pre-excitation may be effected by the microwave energy supply 10. The pressure in the reaction space is maintained within the range between 0.001 to 10 Torr, preferably 0.01 to 0.5 Torr. High frequency electric energy at a frequency not lower than 1 GHz, preferably 2.45 Ghz, is applied to the reactive gas at a power level of from 0.1 to 5 kilo-Watt for breaking C-H bonds. When the frequency is selected to be from 0.1 to 50 MHz, C=C bonds can be broken and transformed to -C-C-bonds. By virtue of this reaction, carbon atoms are deposited in the form of a structure in which the diamond structure occurs at least locally.

A bias voltage of, for example, -200 to 600 V is set at the DC bias source 15. The effective bias voltage level is substantially -400 to +400 V in view of the fact that a self bias level of -200 V is spontaneously applied between the electrodes 11 and 12 with the bias voltage level of the source 15 being zero.

Generally, the high frequency input power is chosen to be between 10 Watts and 5 kilo-Watt, preferably between 50 Watt and 1 kilo-Watt. This input power corresponds to 0.03 to 3 Watt/cm² in terms of plasma energy.

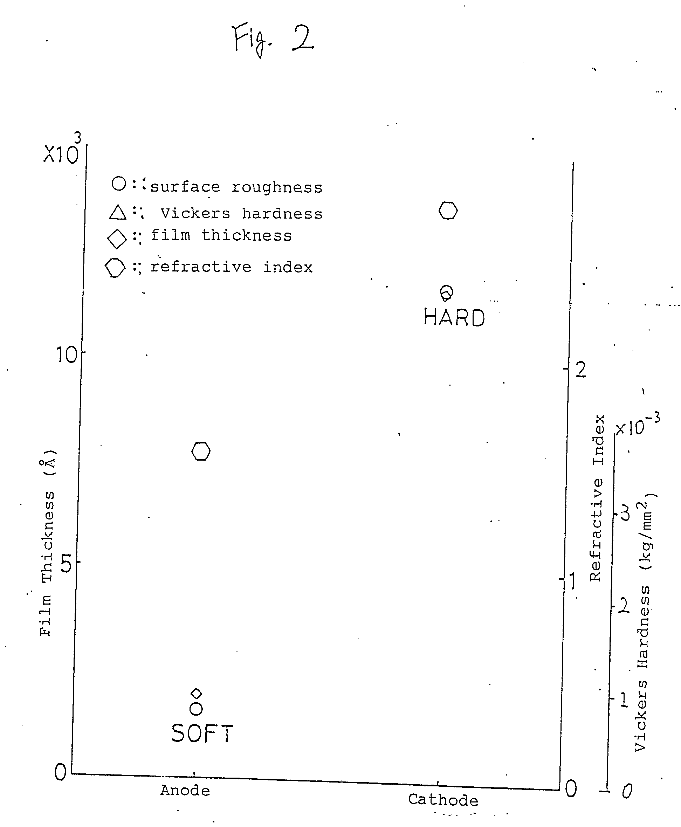

Films were deposited under deposition conditions in which the substrate was used as an anode and films were also deposited under conditions in which the substrate was used as a cathode. The deposition conditions were 60 W (high frequency input power), 0.015 Torr (pressure in the deposition space), 100SCCM (introduction speed of methane (or hydrogen)), room temperature (substrate temperature) and 180 min (deposition time). The results are graphically shown in Fig.2, where circles, triangles, rhombuses and hexagons indicate, respectively, surface roughnesses measured by a needle-contact type tester, Vickers hardnesses measured by a hardness meter, film thicknesses and refractive indices both measured by an elipsometer, of films deposited under the two conditions.

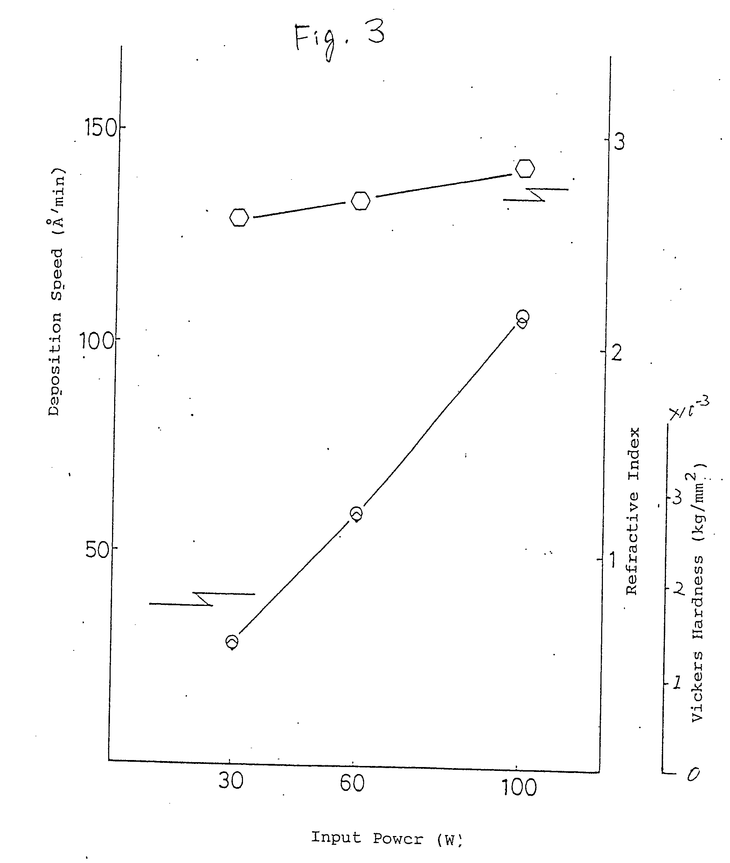

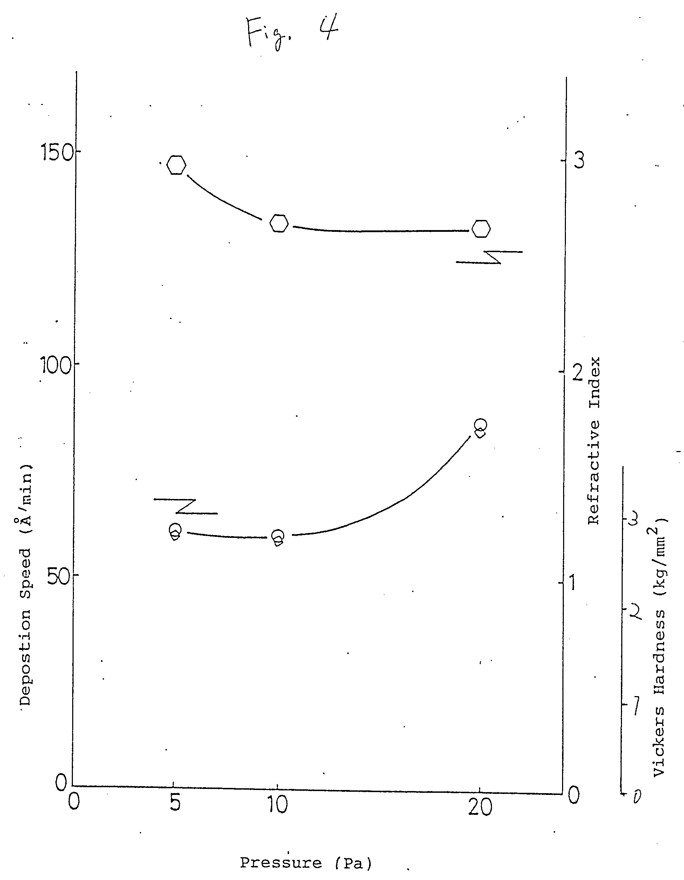

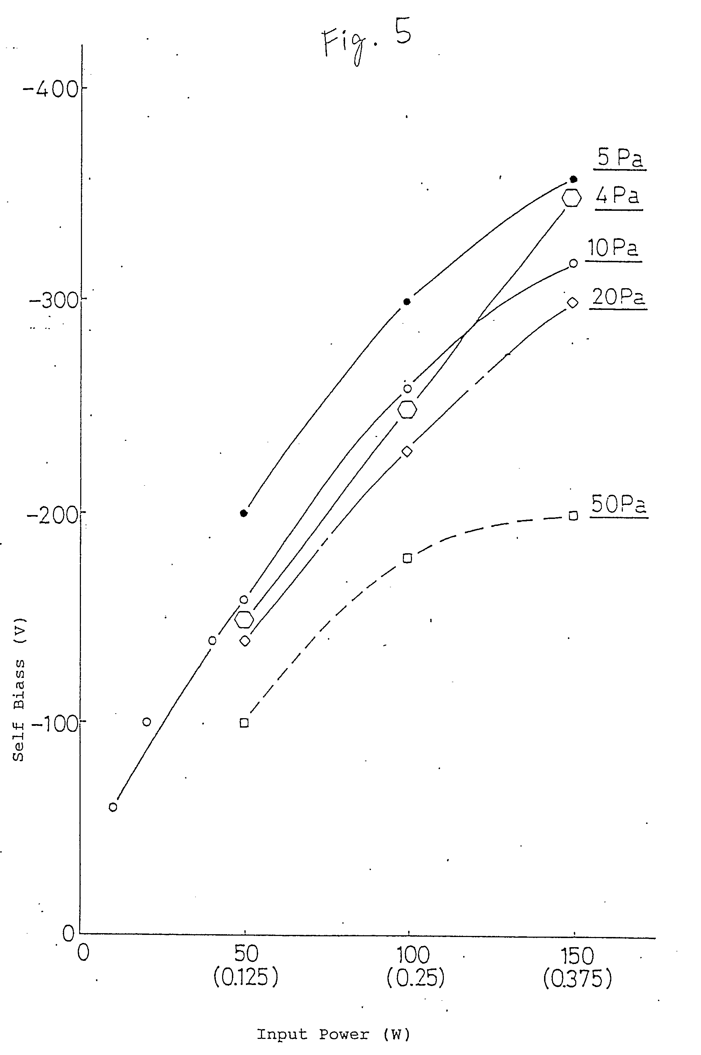

Fig.3 shows the deposition speeds and Vickers hardnesses of films deposited by inputting high frequency electric energy at various power levels. As can be seen from the figure, a harder film was deposited by inputting higher power energy. Fig.4 shows the deposition speeds and Vickers hardnesses of films deposited in the reaction space at various pressure levels. A harder film was deposited at a lower pressure. In Figs.3 and 4, similar symbols are used to indicate similar characteristics as are used in Fig.2. Fig.5 shows the relationship between the pressure in the reaction space and the input power and the self-bias voltage between the electrodes. The figures in parenthesis are equivalent power densities (W/cm²). It can be clearly seen that the higher the input power level of the high frequency power, or the lower the pressure of the reaction space, the stronger is the negative self-bias applied to the electrodes. The symbols used in Fig.5 are not in agreement with those used in Figs.2,3 and 4. Comparing Figs.2 to 5, it will be understood that a higher degree of Vickers hardness can be obtained by increasing the input power level or decreasing the pressure of the reaction space.

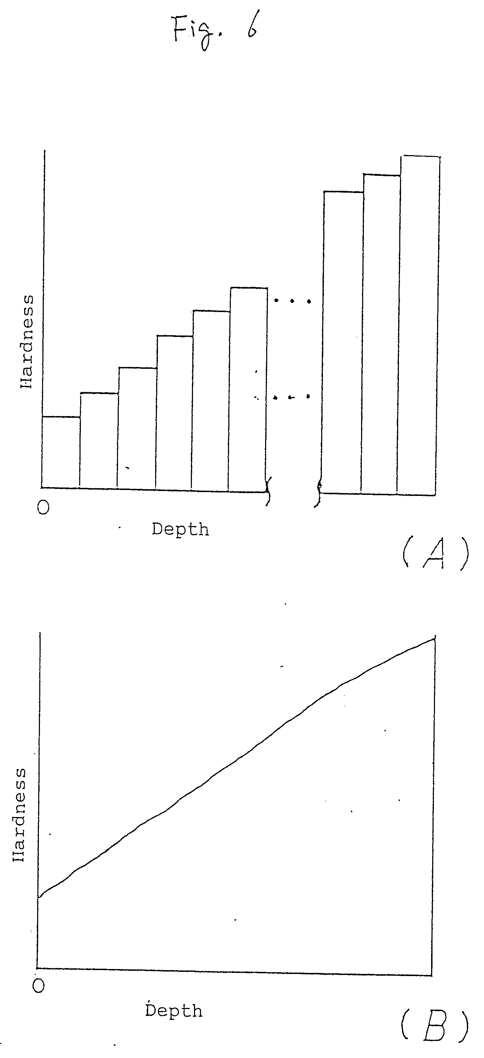

In accordance with the teachings of the present invention therefore, a substrate is coated with a carbon coating while the deposition conditions are changed in order that the hardness of the carbon initially deposited on the substrate will be relatively low and the hardness of the carbon finally deposited will be very high in order to provide a hard external surface. This procedure can be carried out in two ways. As may be seen from Fig.6(A), the hardness may be changed in steps by stepwise variation of the deposition conditions in accordance with the above description. Alternatively, as may be seen from Fig.6(B), the hardness may be changed continuously from the inner surface to the external surface of the carbon coating.

Three exemplary processes for the deposition of carbon thin films in accordance with the teachings of the present invention will now be described.

## Example 1:

Carbon films were deposited on a silicon substrate under various deposition conditions. A first film was deposited on the substrate at a pressure of 0.3 Torr, an input power of 50 W and room temperature (substrate temperature). The deposition time was 150 min. Under these conditions, the self- bias voltage was -200 V. The Vickers hardness of the deposited film was measured to be 2200 $Kg/cm^2$. A second film was deposited on top of the first film at 0.3 Torr, 100 W and 150°C. The deposition time was 150 min. Under these conditions, the self-bias voltage was -150 V. The Vickers hardness of this second film was measured to be 3500 $Kg/cm^2$. Furthermore, a third carbon film was deposited on the second film at 0.015 Torr, 2000 W and room temperature. The deposition time was 60 min. The self-bias voltage was -280 V. The Vickers hardness of this third film was measured to be 4200 $Kg/mm^2$. The other deposition conditions were the same as described in the above description.

## Example 2:

Carbon deposition was carried out for 150 minutes by introducing methane at 100 SCCM together with hydrogen in order to form a first carbon film. The pressure of the reaction space was 0.03 Torr. The input power was 50 W. The other deposition conditions were the same as those for deposition of the first film in Example 1. A second carbon film was deposited on the first film in the same manner except that the input power was 150 W. Also, a third carbon film was deposited on the second film in the same manner except that the input power was 300 W and the deposition time was 60 minutes. As a result, a laminate carbon film was formed whose Vickers hardness was 2200 $Kg/mm^2$ just adjacent to the underlying silicon substrate, 3500 $Kg/mm^2$ at an intermediate depth and 5000 $Kg/mm^2$ at the external surface.

## Example 3:

This example was carried out in order to form a carbon film whose hardness varies continuously across its thickness. Carbon deposition was started under the deposition condition as specified above for the first film of Example 1. Thereafter, the input power was gradually increased to 300 W at a rate of 0.7 to 2 W/min. As a result, a carbon film was obtained whose Vickers hardness gradually increased from 2200 $Kg/mm^2$ at the contiguous surface of the substrate to 4000 $Kg/mm^2$ at the external surface of the carbon film.

When the substrate to be coated was subjected, in advance of carbon deposition, to a plasma of hydrogen at 1 to 10 Torr in order to eliminate impurities such as carbon compounds or nitrogen compounds from the surface to be coated, the contact between the carbon coating and the underlying substrate was further improved. The plasma pressure was selected to be not lower than $10^{-3}$ Torr, and preferably in the range of 0.01 to 200 Torr. The hydrogen plasma was excited by high frequency electric energy of 0.1 to 100 MHz, or by microwaves of 1 to 10 GHz at 10 to 1000 W.

While the invention has been described in the foregoing with particular reference to several embodiments, it is to be appreciated that these are exemplary only and that various modifications and variations may well occur to those possessed of the relevant skills without departure from the scope of the invention. For example, it has been proved effective to add hydrogen, a halogen, boron, nitrogen, phosphorus or the like into the carbon coating. Preferably, the proportion of hydrogen or a halogen is not higher than 25 atomic % and the proportion of the other additives are not higher than 5 %. Also, though the examples were carried out by depositing carbon coatings on semiconductor substrates, the carbon coatings can be deposited on substrates made of an organic resin such as PET (polyethyleneterephthalate), PES, PMMA, teflon, epoxy and polyimides, or on to a metallic mesh, or on to substrates of paper, glass, metals, ceramics and other materials.

The types of carbon coatings that can be deposited in accordance with the present invention includes amorphous, polycrystalline (comprising diamond powders), and diamond films. In the case of a dual film, the lower and upper layers of the film may be, respectively, amorphous and amorphous (having different hardnesses), amorphous and polycrystalline, polycrystalline and polycrystalline or polycrystalline and diamond.

## Claims

1. A method of depositing a thin film coating consisting mainly of carbon onto an object, said method comprising:
placing the object in a reaction chamber;
introducing a productive gas comprising carbon into said reaction chamber; and
inputting energy into said reaction chamber in order to dissociate said carbon compound gas and deposit the carbon product of the dissociation onto a surface of said object,
wherein the conditions for deposition of said carbon coating are changed in order that the hardness of the carbon product initially deposited on said surface is lower than that of the carbon product finally deposited.

2. The method of claim 1 wherein energy is inputted to said reaction chamber by means of a pair of electrodes between which electric energy is supplied, and said object functions as or is carried by one of said electrodes.

3. The method of claim 2 wherein the energy supply to said electrodes is adjusted so that the differential potential between said electrodes on the average increases from the initial stage of the deposition to the final stage of the deposition.

4. The method of claim 3 wherein the average potential of said object is lower than that of the other electrode.

5. The method of claim 3 or 4 wherein said differential potential is varied in steps in order that said carbon coating comprises a lower film having a relatively low hardness and an upper film having a relatively high hardness.

6. The method of claim 3 or 4 wherein said differential potential is gradually varied in order to form a carbon coating whose hardness is substantially continuously increased from the interface between said carbon coating and said substrate to the external surface of said carbon coating.

7. The method of any of claims 3 to 6 wherein said differential potential is increased by decreasing the pressure in said reaction chamber during deposition.

8. The method of claim 7 wherein said pressure is varied in steps in order that said carbon coating comprises a lower film having a relatively low hardness and an upper film having a relatively high hardness.

9. The method of claim 7 wherein said pressure is gradually varied in order to form a carbon coating whose hardness is continuously increased from the interface between said carbon coating and said substrate to the external surface of said carbon coating.

10. The method of any of claims 3 to 9 wherein said differential potential is increased by increasing the input level of said electric energy supplied to said electrodes.

11. A carbon film coating on a substrate or a substrate including such a coating, said coating having a lower degree of hardness in the vicinity of the interface between the carbon film and the substrate and a higher degree of hardness at the external surface of the coating.

12. A CVD process or apparatus for the deposition of carbon thin films wherein the deposition conditions are varied during deposition of a carbon thin film onto a substrate such that the carbon in contact with the substrate has a lesser hardness than the carbon spaced further away from the substrate.

Fig. 1

Fig. 2

○ :: surface roughness
△ :: Vickers hardness
◇ :: film thickness
⬡ :: refractive index

Film Thickness (Å)

Refractive Index

Vickers Hardness (kg/mm²)

HARD

SOFT

Anode

Cathode

Fig. 3

Fig. 4

Fig. 5

Fig. 6

(A)

(B)

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 157 212 (AMERICAN CYANAMID CO.) * Abstract; page 5, line 33 - page 6, line 7 * | 1,11,12 | C 23 C 16/26 <br> C 30 B 29/04 <br> C 23 C 16/50 <br> C 23 C 16/52 |
| X | EP-A-0 267 679 (OVONIC SYNTHETIC MATERIALS CO. INC.) * Column 4, paragraph 1; column 8, lines 9-20 * | 1,11,12 | |
| Y | | 2-10 | |
| Y | JOURNAL OF VACUUM SCIENCE & TECHNOLOGY/A, vol. 3, no. 3, May-June 1985, Part 1, pages 681-685, American Vacuum Society, Woodbury, US; V. NATARAJAN et al.: "Diamondlike" carbon films: Optical absorption, dielectric properties, and hardness dependence on deposition parameters" * Page 681, section II,A; page 683, section III,C * | 2-10 | |

TECHNICAL FIELDS SEARCHED (Int. Cl.4)

C 23 C

The present search report has been drawn up for all claims

| Place of search | Date of completion of the search | Examiner |
|---|---|---|
| THE HAGUE | 01-06-1989 | PATTERSON A.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)